# FASCICULE DE BREVET EUROPEEN

(11) **EP 0 544 568 B1**
(45) Date de publication et mention de la délivrance du brevet: **10.08.1994**
(21) Numéro de dépôt: 92403117.2
(22) Date de dépôt: 19.11.1992
(51) Int. Cl.: G06F 11/20, G11C 16/06

(54) **Circuit de lecture de fusible de redondance pour mémoire intégrée**
Leseschaltkreis für redundante Schmelzsicherung für integrierten Speicher
Reading circuit for redundancy fuse for integrated memory

(30) Priorité: 25.11.1991 FR 9114506
(43) Date de publication de la demande: 02.06.1993
(73) Titulaire: SGS-THOMSON MICROELECTRONICS S.A., 94250 Gentilly (FR)
(72) Inventeur: Drouot, Sylvie, Cabinet Ballot-Schmit, F-75116 Paris (FR)
(74) Mandataire: Schmit, Christian Norbert Marie

(56) Documents cités:
- GB-A- 2 123 587
- US-A- 4 532 611
- US-A- 5 034 925

## Description

L'invention concerne les mémoires réalisées en circuits intégrés, et plus particulièrement celles qui comportent des circuits de redondance.

Une mémoire intégrée comporte de nombreuses cellules de mémoire en lignes et en colonnes sur une très petite surface et un défaut technologique sur une seule cellule entraîne la mise au rebut de la totalité de la mémoire. Pour éviter cela on utilise des circuits de redondance qui sont mis en service si un défaut est constaté au moment du test de la mémoire.

Le plus souvent, la mémoire comportera plusieurs lignes ou plusieurs colonnes de remplacement (ou à la fois plusieurs lignes et plusieurs colonnes). Chaque ligne ou colonne de remplacement peut être substituée à une ligne ou une colonne défectueuse de la mémoire.

Mais le remplacement doit être transparent pour l'utilisateur, c'est-à-dire que celui-ci doit pouvoir appliquer à l'entrée de la mémoire l'adresse de la ligne ou colonne défectueuse pour lire ou écrire à cette adresse exactement comme si elle n'était pas défectueuse. L'adresse des lignes ou colonnes défectueuses est donc enregistrée à l'intérieur du circuit intégré; lorsque l'utilisateur présente à l'entrée de la mémoire une adresse de ligne ou colonne défectueuse, ce sont les circuits internes de la mémoire qui reconnaissent qu'il s'agit d'une des adresses défectueuses enregistrées, et qui aiguillent les signaux électriques vers les colonnes de remplacement. L'utilisateur n'intervient en rien dans ce processus.

Pour enregistrer les adresses défectueuses, on a utilisé et on utilise toujours ce qu'on appelle au sens large des "fusibles" : un fusible définit une information binaire selon son état (vierge ou programmé); pour chaque adresse défectueuse à enregistrer, on utilise une batterie de plusieurs fusibles, en nombre égal au nombre de bits servant à définir une adresse. Pour une adresse de p bits, il y a une batterie de p fusibles. L'état intact ou programmé des différents fusibles d'une batterie définit une adresse de p bits. S'il y a N lignes ou colonnes de redondance, c'est-à-dire si on veut pouvoir remplacer N lignes ou colonnes défectueuses par des lignes ou colonnes de remplacement, il faut N batteries.

Lorsqu'on a besoin d'un élément de remplacement pour remplacer un élément défectueux, on stocke l'adresse de cet élément défectueux dans une batterie de fusibles et on grille un fusible de validation associé à cette batterie pour indiquer qu'elle est effectivement utilisée pour définir une opération de remplacement.

Les fusibles peuvent être des fusibles physiques (élément de circuit ouvert qui est transformé en court-circuit lorsqu'il est grillé, ou le contraire); ou alors, plus fréquemment maintenant, les fusibles peuvent être des éléments de mémoire non volatile tels que des transistors UPROM ("unerasable programmable read-only memory"); ces transistors sont programmés électriquement et ne peuvent plus être effacés ensuite. L'état vierge du transistor correspond à un état original du "fusible"; l'état programmé du transistor correspond à un état grillé du fusible.

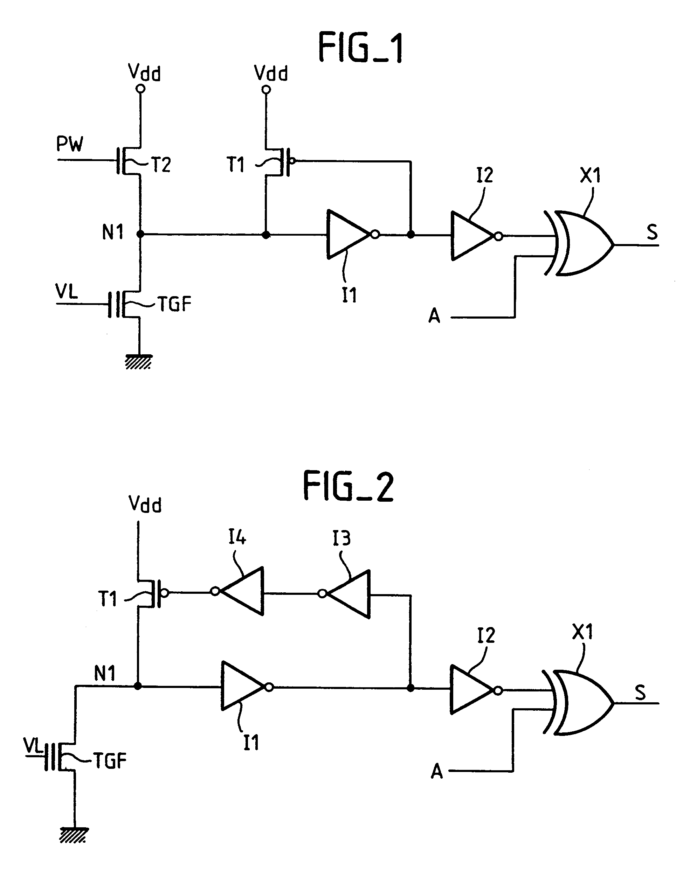

La figure 1 représente une partie d'un circuit de redondance de l'art antérieur; cette partie est destinée à stocker un bit d'adresse d'élément défectueux et à comparer le bit stocké à un bit correspondant de l'adresse reçue; la comparaison de l'adresse reçue et de l'adresse stockée définit s'il y a lieu de mettre en service la redondance. Il y a donc autant de circuits comme celui de la figure 1 qu'il y a de bits dans l'adresse de l'élément défectueux à remplacer.

Le bit d'adresse défectueuse est stocké dans un fusible consistant ici en un transistor à grille flottante TGF de type UPROM. L'état vierge ou programmé de ce transistor définit la valeur du bit stocké. Une tension de lecture VL est appliquée à la grille de commande de ce transistor. Si le transistor TGF est resté dans un état vierge (non programmé), c'est que le bit d'adresse stocké est un bit zéro; dans ce cas le transistor TGF est conducteur en présence de la tension de lecture VL; si au contraire le transistor TGF a été programmé, le bit d'adresse stocké est un 1; dans ce cas le transistor reste bloqué malgré la tension de lecture VL.

Un convertisseur courant-tension constitué par un transistor T1 à canal P et deux inverseurs I1 et I2 permet de lire le courant circulant dans le transistor TGF pour déterminer s'il est conducteur ou bloqué. Ce convertisseur fournit un niveau de tension logique 0 si le transistor TGF est conducteur, donc si le bit stocké est 0, et un niveau de tension logique 1 si le transistor TGF est bloqué, donc si le bit stocké est 1.

Une porte OU-exclusif X1 reçoit d'une part la sortie du convertisseur (sortie de I2) et d'autre part un bit A de l'adresse reçue à un moment donné par la mémoire. Comme on l'a indiqué ci-dessus, si l'adresse appliquée comporte p bits, alors il y a p circuits identiques à celui de la figure 1, chaque circuit effectuant la comparaison entre un bit d'adresse reçu Ai et un bit d'adresse stocké de même rang i. Ce n'est que s'il y a coïncidence bit à bit de l'adresse reçue et l'adresse stockée que l'on mettra en service la redondance.

Si le bit d'adresse reçue est identique au bit stocké, la porte OU-exclusif fournit un 0 logique; sinon elle fournit un 1. Ce n'est que si toutes les sorties de portes OU-exclusif correspondant aux différents bits sont à 0 que la redondance doit être mise en service. Une porte NOR non représentée reçoit toutes les sorties S des portes OU-exclusif et ne délivre un 1 logique que si toutes ses entrées sont simultanément à 0. Elle reçoit d'ailleurs une entrée supplémentaire correspondant à un fusible de validation, entrée qui n'est à 0 que si le fusible de validation a été programmé.

Le convertisseur courant tension (T1, I1, I2) comporte plus précisément un premier inverseur I1 dont l'entrée est reliée à un noeud de circuit NI qui est le drain du transistor TGF. La sortie de l'inverseur I1 est reliée à la grille d'un transistor T1 à canal P dont la source est à une tension d'alimentation positive Vdd et le drain est relié au noeud N1. Les dimensions relatives du transistor T1 et des transistors constituant l'inverseur I1 permettent de régler les seuils de courant provoquant le basculement de l'inverseur I1 dans un sens ou dans un autre. L'inverseur I2, en cascade avec la sortie de l'inverseur I1, est facultatif; dans le cas présent il inverse le niveau logique de sortie de l'inverseur I1 pour définir un niveau logique 0 lorsque le transistor TGF est vierge et conducteur.

Enfin, pour terminer la description de la figure 1, un transistor T2, contrôlé par un signal logique PW, est connecté entre l'alimentation Vdd et le noeud N1. Le signal PW est créé par un circuit de remise sous tension non représenté ("power-on-reset" en anglais). Ce signal est classiquement engendré quelques instants après la remise sous tension du circuit intégré; il sert à établir franchement un niveau logique 1 sur le noeud N1 après la remise sous tension lorsque le transistor TGF est dans un état programmé (donc non conducteur malgré la tension de lecture VL). En effet, dans ce cas, au moment de la remise sous tension, le noeud N1 est flottant (TGF non conducteur); au départ son potentiel peut être proche de zéro, ce qui porte la sortie de l'inverseur I1 à 1 et qui confirme le blocage du transistor T1; le noeud N1 reste donc flottant et n'a aucune raison de tendre vers 1, ce qu'il devrait pourtant faire pour représenter l'état programmé du transistor TGF. Ceci est d'autant plus vrai qu'il y a des capacités parasites importantes entre le noeud N1 et la masse. Pour éviter cela, le signal PW rend franchement conducteur le transistor T2 pendant un bref instant, après la remise sous tension, ce qui porte le noeud N1 à 1; la sortie de l'inverseur I1 passe à 0 et rend conducteur le transistor T1, confirmant ensuite l'état 1 du noeud 1 même après disparition du signal PW.

Un des buts de la présente invention est d'éviter d'avoir à utiliser un signal de remise sous tension PW. Le circuit qui produit ce signal est en effet délicat à mettre au point, il est encombrant, et il consomme un courant important.

Une tentative a été faite en plaçant une capacité entre la sortie de l'inverseur I1 et la masse. Si cette capacité est déchargée au moment de la remise sous tension, elle va tendre à maintenir le transistor T1 conducteur pendant un certain temps au cours de la remise sous tension et le noeud N1 aura donc le temps de monter à 1 grâce au transistor T1, après quoi la situation sera normale. L'expérience a montré que cette solution n'est pas satisfaisante, d'une part parce que la capacité est encombrante et d'autre part parce qu'elle est mal caractérisée en technologie des circuits intégrés; on a des incertitudes sur sa valeur et donc sur son fonctionnement.

C'est pourquoi on propose selon l'invention un circuit qui fournit une solution satisfaisante à ce problème, en particulier en éliminant la nécessité d'un signal PW de remise sous tension, et ceci sans détériorer les autres caractéristiques du circuit.

Selon l'invention, on propose de supprimer le transistor T2 et de placer entre la sortie de l'inverseur I1 et la grille du transistor T1 deux inverseurs supplémentaires en série, chacun d'eux comportant deux transistors très dissymétriques, et la dissymétrie étant dans le sens contraire pour les deux inverseurs.

Cette dissymétrie est dans un sens tendant à faciliter la mise en conduction du transistor T1 du convertisseur de courant.

L'invention propose donc une mémoire intégrée comportant un circuit de redondance avec au moins une batterie de fusibles définissant une adresse d'élément défectueux et un moyen pour mettre en service un élément de réparation lorsqu'une adresse appliquée à la mémoire correspond à une adresse stockée dans la batterie de fusibles, le circuit de redondance comportant, associé à chaque fusible, un convertisseur courant-tension ayant une entrée reliée au fusible, ce convertisseur comportant un inverseur dont l'entrée constitue l'entrée du convertisseur et dont la sortie commande la grille d'un transistor de rebouclage, ce transistor ayant sa source reliée à une tension d'alimentation et son drain relié à l'entrée de l'inverseur, la mémoire étant caractérisée en ce qu'un ensemble de deux inverseurs supplémentaires en série est placé entre la sortie du premier inverseur et la grille du transistor, les inverseurs comportant chacun deux transistors très dissymétriques et la dissymétrie s'exerçant en sens inverse pour les deux inverseurs.

L'invention est applicable non seulement pour le cas particulier des circuits de redondance de mémoire mais aussi pour tous les cas où un problème similaire se pose. C'est pourquoi l'invention propose plus généralement un circuit de lecture de l'état d'une cellule de mémoire, comportant un convertisseur courant-tension constitué par un inverseur et un transistor de rebouclage, caractérisé en ce que la sortie de l'inverseur est reliée à la grille du transistor de rebouclage par l'intermédiaire de deux inverseurs en série, comportant chacun deux transistors très dissymétriques, la dissymétrie étant en sens inverse pour les deux inverseurs.

Le premier inverseur aura un transistor d'un premier type de conductivité dont le rapport largeur sur longueur de canal est beaucoup plus grand que 1 et un transistor d'un deuxième type de conductivité dont le rapport largeur sur longueur de canal est beaucoup plus petit que 1. Et pour le deuxième inverseur ce sera l'inverse.

Dans une réalisation préférée, le transistor dont la grille est commandée par l'intermédiaire de l'ensemble de deux inverseurs en série est un transistor MOS à canal P. Le premier inverseur a un transistor à canal P de grand rapport largeur/longueur de canal, et un transistor à canal N de petit rapport largeur/longueur de canal. Le deuxième inverseur a au contraire un transistor à canal P de petit rapport largeur/longueur de canal et un transistor à canal N de grand rapport largeur/longueur de canal.

D'autres caractéristiques et avantages de l'invention apparaîtront à la lecture de la description détaillée qui suit et qui est faite en référence aux dessins annexés dans lesquels :
- la figure 1 déjà décrite représente un schéma partiel de circuit de redondance d'une mémoire de l'art antérieur;
- la figure 2 représente un schéma modifié selon l'invention;
- la figure 3 représente le détail des inverseurs utilisés;
- la figure 4 représente un schéma détaillé d'un circuit de redondance incorporant l'invention.

La mémoire selon l'invention peut comporter classiquement un réseau de lignes et colonnes de cellules adressables au moyen d'un décodeur de ligne et d'un décodeur de colonne. Le décodeur de ligne sert à désigner une ligne déterminée lorsqu'il reçoit une adresse de ligne. Le décodeur de colonne reçoit une adresse de colonne et commande en conséquence un multiplexeur pour désigner un mot déterminé de la ligne sélectionnée. Le multiplexeur sélectionne alors des colonnes correspondant à ce mot et permet de connecter ces colonnes à des plots d'entrée-sortie. Ces plots servent à transmettre, en lecture ou en écriture, un mot de données enregistrées dans la mémoire. Cette organisation, bien qu'elle ne soit pas la seule possible, est la plus généralement utilisée et sera prise comme base d'illustration de la présente invention.

Le circuit intégré comporte par ailleurs une circuiterie de redondance.

Pour simplifier on considère que les seuls éléments de redondance sont des colonnes de réparation destinées à remplacer des colonnes défectueuses. Mais il pourrait aussi y avoir des lignes de réparation pour remplacer des lignes défectueuses.

On prévoit pour chaque colonne de réparation un circuit de redondance respectif. Ce circuit possède les fonctions suivantes :
- il possède en mémoire l'adresse de la colonne défectueuse;
- il reçoit les adresses de colonne appliquées à l'entrée de la mémoire;
- il reste inactif si l'adresse ne correspond pas à l'adresse enregistrée;
- il aiguille la colonne de réparation vers les plots d'entrée-sortie à la place de la colonne défectueuse lorsqu'il reçoit l'adresse correspondant à la colonne défectueuse.

Le coeur du circuit de redondance modifié selon l'invention est représenté à la figure 2.

Comme pour le circuit de la figure 1, il faut comprendre que le circuit de la figure 2 ne correspond qu'au stockage d'un bit d'adresse d'élément défectueux, et que l'ensemble de la circuiterie de redondance comprend pour chaque colonne défectueuse à remplacer autant de circuits du type de la figure 2 qu'il y a de bits dans l'adresse de colonne.

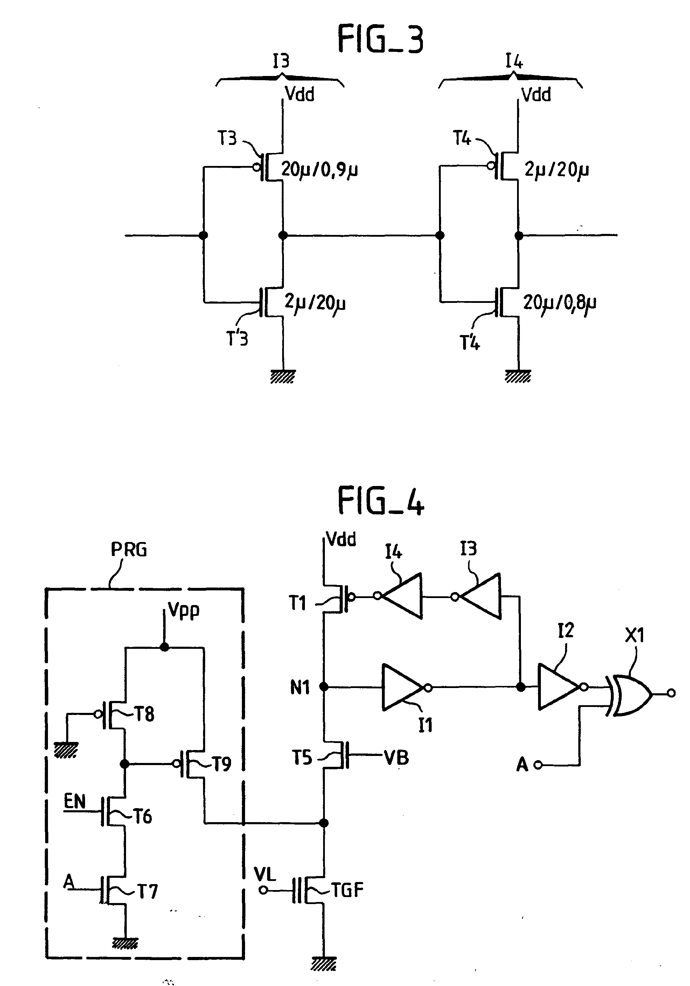

Par ailleurs, pour simplifier le dessin, on n'a pas représenté à la figure 2 la circuiterie servant à programmer l'état du fusible. Et on n'a pas représenté des éléments de circuit qui n'ont pas d'incidence sur la compréhension de l'invention. Un schéma plus complet est cependant donné à la figure 4.

Comme pour la description de la figure 1, le fusible est supposé être ici aussi un transistor à grille flottante électriquement programmable et non effaçable.

Tous les éléments identiques à ceux de la figure 1 et connectés de la même manière portent les mêmes références et ne seront pas re-décrits. Ils jouent le même rôle que celui qui a été décrit en référence à la figure 1. Il s'agit du transistor TGF et de sa tension de lecture VL, de l'inverseur I1 et du transistor de rebouclage T1 faisant partie du convertisseur courant-tension qui sert à lire l'état du fusible, de l'inverseur facultatif I2, et de la porte OU-Exclusif X1 recevant la sortie du convertisseur courant-tension et un bit d'adresse courante A.

Le convertisseur courant-tension comporte encore essentiellement l'inverseur I1 et le transistor T1. Le transistor T1 est de préférence à canal P et connecté alors entre l'alimentation positive Vdd et l'entrée de l'inverseur I1 (entrée elle-même connectée au drain du transistor TGF qui a sa source à la masse).

Au lieu que la sortie de l'inverseur I1 commande directement la grille du transistor T1, on voit sur la figure que cette sortie est reliée à un ensemble en série de deux inverseurs I3 et I4, la sortie de cet ensemble étant reliée à la grille de T1.

Le niveau de tension logique appliqué à la grille de T1 est le même que si la commande était directe mais le fonctionnement en régime de démarrage est différent à cause des caractéristiques particulières des transistors constituant les inverseurs I3 et I4. Ces inverseurs sont tous deux très dissymétriques, c'est-à-dire qu'ils possèdent chacun deux transistors de dimensions très différentes. Et la dissymétrie est en sens inverse pour les deux inverseurs.

La figure 3 représente un exemple de réalisation qui illustre cette particularité.

Les deux inverseurs I3 et I4 de la figure 3 sont constitués classiquement chacun d'un transistor MOS à canal P (T3 pour I3, T4 pour I4) en série avec un transistor MOS à canal N (T′3 pour I3, T′4 pour I4); les grilles des deux transistors sont réunies pour faire l'entrée de l'inverseur; les drains sont réunis pour constituer la sortie de l'inverseur. La source du transistor à canal P (T3, T4) est reliée à l'alimentation positive Vdd; la source du transistor à canal N (T′3, T′4) est reliée à la masse.

Le transistor T3 a de préférence un rapport largeur sur longueur de canal très supérieur à 1, de préférence d'au moins 10 et même supérieur à 20. Dans l'exemple préféré le rapport est de 20 unités sur 0,9 unités. Le mot unité est pris dans le sens unité de longueur dans le dessin du circuit intégré. L'unité de longueur est par exemple d'environ 2 micromètres dans la mémoire.

On rappelle que la longueur du canal est prise dans le sens de circulation du courant, la largeur étant dans le sens transversal. Le transistor T3 est donc un transistor à canal P susceptible de passer un courant important vu sa grande largeur.

Au contraire le transistor T′3, à canal N, a un rapport largeur/longueur très inférieur à 1. La dissymétrie entre les deux transistors de l'inverseur est donc très forte. De préférence le rapport largeur/longueur est inférieur à 1/5, ou même 1/10. Dans l'exemple représenté il est de 2 unités sur 20 unités.

Pour l'inverseur I4, la situation est exactement inversée : le transistor à canal P T4 a un faible rapport largeur /longueur, comme le transistor à canal N T′3 de I3, et le transistor à canal N T′4 a un grand rapport largeur/longueur comme le transistor T3.

Dans l'exemple représenté, T4 a une largeur de canal de 2 unités et une longueur de 20 unités (rapport 1/10); et T′4 a une largeur de 20 unités et une longueur de 0,8 unités (rapport 25).

Il en résulte le fonctionnement suivant dans le cas où d'une part le fusible est programmé et d'autre part la tension d'alimentation Vdd a été coupée et vient d'être remise : la sortie de I1 est supposée initialement déchargée; le transistor T3 tend très facilement à devenir plus conducteur que T′3 puisque d'une part sa grille est à un potentiel relativement bas et d'autre part sa résistance interne propre est beaucoup plus faible que celle de T′3. La sortie de I3 reste donc facilement proche de la tension d'alimentation Vdd.

Pour l'inverseur I4 c'est le contraire : la grille de T′4 (canal N) est à un potentiel relativement élevé et ce transistor a une résistance interne beaucoup plus faible que celle de T4. La sortie de l'inverseur I4 tend donc très facilement à se rapprocher de zéro. Ceci rend conducteur le transistor T1 qui autorise donc la montée vers Vdd du potentiel du noeud flottant N1. Même si le noeud N1 était au départ à zéro, ce qui tendrait à faire basculer les inverseurs I3 et I4 dans le sens contraire de ce qui vient d'être dit, la forte dissymétrie des inverseurs oblige le transistor T1 à conduire très rapidement et pendant un temps suffisant pour que le noeud N1 monte assez haut et confirme alors les sens de basculement adoptés dès le départ.

Dans le cas où le transistor à grille flottante TGF est vierge, il n'y a pas de problème. Dès que la tension d'alimentation Vdd commence à monter, le transistor TGF devient conducteur, tirant le noeud A vers zéro et faisant basculer les inverseurs I3 et I4 dans un sens tendant à bloquer T1. Il n'y a pas de risque que le noeud N1 reste flottant. Pour être sûr du sens de basculement, il est préférable cependant de prévoir que le transistor T1 a un faible rapport largeur/longueur de canal par rapport au transistor TGF. A titre d'exemple TGF a un rapport d'environ 1 unité sur 1 unité et T1 d'environ 2 unités sur 40 unités.

La figure 4 représente un exemple de réalisation détaillé du circuit de redondance. Ce circuit reprend pour l'essentiel le schéma de la figure 2, auquel on a rajouté les éléments nécessaires à la programmation du transistor à grille flottante TGF. L'état vierge ou programmé dépend de la valeur du bit d'adresse à stocker, c'est-à-dire de la valeur du bit d'adresse A appliqué à la mémoire au moment où une panne est détectée et où on décide donc d'affecter une batterie de fusible à la réparation de cette panne.

Le circuit de programmation est désigné par la référence PRG. Pour la programmation, le drain du transistor TGF est isolé du convertisseur courant-tension (I1, T1, I3, I4) par un transistor T5 commandé par une tension de polarisation VB. Cette tension bloque le transistor pendant la programmation et le rend conducteur pendant l'utilisation de la mémoire.

Le circuit PRG comporte des moyens pour appliquer au transistor TGF la tension Vpp relativement élevée nécessaire à sa programmation. Cette circuiterie est par exemple déclenchée par un signal EN appliqué à la grille d'un transistor T6. Et elle est validée ou non (selon que le fusible doit rester vierge ou être programmé) par le bit d'adresse A appliqué à la grille d'un transistor T7. Sur la figure, le transistor T8 joue le rôle de résistance pour limiter le courant dans la branche T6, T7, T8. Un transistor T9 commandé par le drain de T6 sert à appliquer la tension Vpp au drain de TGF lors de la présence simultanée du signal de programmation EN et d'un bit d'adresse A égal à 1.

Enfin, la tension appliquée à la grille de commande du transistor à grille flottante est, en mode d'utilisation, une tension VL apte à le rendre conducteur s'il est vierge et inapte à le rendre conducteur s'il est programmé. En mode de programmation, la tension appliquée à la grille de commande de TGF est celle qui convient pour charger la grille flottante; elle dépend du type de transistor utilisé.

## Revendications

1. Mémoire intégrée comportant un circuit de redondance avec au moins une batterie de fusibles définissant une adresse d'élément défectueux et un moyen pour mettre en service un élément de réparation lorsqu'une adresse appliquée à la mémoire correspond à une adresse stockée dans la batterie de fusibles, le circuit de redondance comportant, associé à chaque fusible (TGF), un convertisseur courant-tension (I1, T1) ayant une entrée reliée au fusible, ce convertisseur comportant un inverseur (I1) dont l'entrée constitue l'entrée du convertisseur et dont la sortie commande la grille d'un transistor (T1), ce transistor ayant sa source reliée à une tension d'alimentation (Vdd) et son drain relié à l'entrée de l'inverseur, la mémoire étant caractérisée en ce qu'un ensemble de deux inverseurs supplémentaires en série (I3, I4) est placé entre la sortie du premier inverseur (I1) et la grille du transistor, les inverseurs comportant chacun deux transistors très dissymétriques et la dissymétrie s'exerçant en sens inverse pour les deux inverseurs.

2. Mémoire intégrée selon la revendication 1, caractérisée en ce que le premier inverseur supplémentaire (I3) comporte un transistor d'un premier type de conductivité dont le rapport largeur sur longueur de canal est beaucoup plus grand que 1 et un transistor d'un deuxième type de conductivité dont le rapport largeur sur longueur de canal est beaucoup plus petit que 1.

3. Mémoire selon la revendication 2, caractérisée en ce que le deuxième inverseur (I4) comporte un transistor du premier type de conductivité dont le rapport largeur sur longueur de canal est beaucoup plus petit que 1 et un transistor du deuxième type de conductivité dont le rapport largeur sur longueur de canal est beaucoup plus grand que 1.

4. Mémoire selon l'une des revendications 1 à 3, caractérisée en ce que le transistor (T1) dont la grille est commandée par l'intermédiaire de l'ensemble de deux inverseurs en série (I3, I4) est un transistor MOS à canal P, en ce que le premier inverseur comporte un transistor à canal P de grand rapport largeur/longueur de canal et un transistor à canal N de petit rapport largeur/longueur de canal, et en ce que le deuxième inverseur comporte un transistor à canal P de petit rapport largeur/longueur de canal et un transistor à canal N de grand rapport largeur/longueur de canal.

5. Circuit de lecture de l'état d'une cellule binaire, comportant un inverseur (I1) connecté à ladite cellule (TGF) et un transistor de rebouclage (T1) dont la source est reliée à une tension d'alimentation, et le drain est relié à l'entrée de l'inverseur, caractérisé en ce que la sortie de l'inverseur est reliée à la grille du transistor par l'intermédiaire de deux inverseurs en série (I3, I4), comportant chacun deux transistors très dissymétriques, la dissymétrie étant en sens inverse pour les deux inverseurs.

6. Circuit de lecture selon la revendication 5, caractérisé en ce que l'un des inverseurs supplémentaires comporte un transistor à canal P de grand rapport largeur/longueur de canal et un transistor à canal N de petit rapport largeur/longueur de canal, et en ce que l'autre inverseur supplémentaire comporte un transistor à canal P de petit rapport largeur/longueur de canal et un transistor à canal N de grand rapport largeur/longueur de canal.

## Patentansprüche

1. Integrierter Speicher, umfassend einen Redundanzkreis mit wenigstens einer Batterie von Sicherungen, die eine Adresse eines defekten Elementes definieren, und ein Mittel zum Inbetriebsetzen eines Reparaturelementes, wenn eine zum Speicher gegebene Adresse einer in der Sicherungsbatterie gespeicherten Adresse entspricht, wobei der Redundanzkreis jeder Sicherung (TGF) zugeordnet einen Strom-Spannungswandler (I1, T1) umfaßt, von dem ein Eingang mit der Sicherung verbunden ist, wobei der Wandler ein Invertierglied (I1) umfaßt, dessen Eingang den Eingang des Wandlers bildet und dessen Ausgang das Gate eines Transistors (T1) steuert, wobei die Source des Transistors mit einer Versorgungsspannung (Vdd) verbunden ist und sein Drain mit dem Eingang des Invertiergliedes verbunden ist, wobei der Speicher dadurch **gekennzeichnet** ist, daß ein Satz von zwei zusätzlichen Invertiergliedern in Reihe (I3, I4) zwischen dem Ausgang des ersten Invertiergliedes (I1) und dem Gate des Transistors angeordnet ist, wobei die Invertierglieder jeweils zwei sehr asymmetrische Transistoren umfassen und sich die Asymmetrie in umgekehrter Richtung auf die beiden Invertierglieder auswirkt.

2. Integrierter Speicher nach Anspruch 1, dadurch **gekennzeichnet**, daß das erste zusätzliche Invertierglied (I3) einen Transistor eines ersten Leitfähigkeitstyps, dessen Verhältnis Kanalbreite zu -länge viel größer als 1 ist, und einen Transistor eines zweiten Leitfähigkeitstyps umfaßt, dessen Verhältnis Kanalbreite zu -länge viel kleiner als 1 ist.

3. Speicher nach Anspruch 2, dadurch **gekennzeichnet**, daß das zweite Invertierglied (I4) einen Transistor des ersten Leitfähigkeitstyps, dessen Verhältnis Kanalbreite zu -länge viel kleiner als 1 ist und einen Transistor des zweiten Leitfähigkeitstyps umfaßt, dessen Verhältnis Kanalbreite zu -länge viel größer als 1 ist.

4. Speicher nach einem der Ansprüche 1 bis 3, dadurch **gekennzeichnet**, daß der Transistor (T1), dessen Gate mittels des Satzes von zwei Invertiergliedern in Reihe (I3, I4) gesteuert ist, ein MOS-Transistor mit P-Kanal ist, daß das erste Invertierglied einen Transistor mit P-Kanal mit großem Verhältnis Kanalbreite/länge und einem Transistor mit N-Kanal mit kleinem Verhältnis Kanalbreite/länge umfaßt, und daß das zweite Invertierglied einen Transistor mit P-Kanal mit kleinem Verhältnis Kanalbreite/länge und einen Transistor mit N-Kanal mit großem Verhältnis Kanalbreite/länge umfaßt.

5. Lesekreis zum Lesen des Zustandes einer Binärzelle, umfassend ein mit der Zelle (TGF) verbundenes Invertierglied (I1) und einen Rückschleifentransistor (T1), dessen Source mit einer Versorgungsspannung verbunden ist und dessen Drain mit dem Eingang des Invertiergliedes verbunden ist, dadurch **gekennzeichnet**, daß der Ausgang des Invertiergliedes mit dem Gate des Transistors mittels zweier Invertierglieder in Reihe (I3, I4) verbunden ist, umfassend jeweils zwei sehr asymmetrische Transistoren, wobei die Asymmetrie für die beiden Invertierglieder in umgekehrter Richtung ist.

6. Lesekreis nach Anspruch 5, dadurch **gekennzeichnet**, daß das eine der zusätzlichen Invertierglieder einen Transistor mit P-Kanal mit großem Verhältnis Kanalbreite/länge und einen Transistor mit N-Kanal mit kleinem Verhältnis Kanalbreite/länge umfaßt und daß das andere zusätzliche Invertierglied einen Transistor mit P-Kanal mit kleinem Verhältnis Kanalbreite/länge und einen Transistor mit N-Kanal mit großem Verhältnis Kanalbreite/länge umfaßt.

## Claims

1. Integrated memory including a redundant circuit with at least one fuse array defining the address of a defective component and a means for bringing a repair component into operation when an address applied to the memory corresponds to an address stored in the fuse array, the redundant circuit including, associated with each fuse (TGF), a current-to-voltage converter (I1, T1) with one input connected to the fuse, this converter having an inverter (I1), the input of which constitutes the input of the converter and the output of which controls the gate of a transistor (T1), this transistor having its source connected to a supply voltage (Vdd) and its drain connected to the input of the inverter, the memory being characterised in that a set of two supplementary inverters in series (I3, I4) is placed between the output of the first inverter (I1) and the gate of the transistor, the inverters each having two highly asymmetrical transistors and the asymmetry occurring in opposite directions for the two inverters.

2. Integrated memory according to Claim 1, characterised in that the first supplementary inverter (I3) includes a transistor with a first type of conductivity, the width-to-length ratio of the channel of which is much greater than 1 and a transistor with a second type of conductivity, the width-to-length ratio of the channel of which is much less than 1.

3. Memory according to Claim 2, characterised in that the second inverter (I4) includes a transistor with the first type of conductivity, the width-to-length ratio of the channel of which is much less than 1, and a transistor with the second type of conductivity, the width-to-length ratio of the channel of which is much greater than 1.

4. Memory according to one of Claims 1 to 3, characterised in that the transistor (T1), the gate of which is controlled by means of the set of two inverters in series (I3, I4), is a p-channel MOS transistor, in that the first inverter has a p-channel transistor with a high channel width/length ratio and an n-channel transistor with a low channel width/length ratio, and in that the second inverter has a p-channel transistor with a low channel width/length ratio and a n-channel transistor with a high channel width/length of channel.

5. Circuit for reading the state of a binary cell, having an inverter (I1) connected to the said cell (TGF) and a feedback transistor (T1), the source of which is connected to a supply voltage and the gate of which is connected to the input of the inverter, characterised in that the output of the inverter is connected to the gate of the transistor by means of two inverters in series (I3, I4), each having two highly asymmetrical transistors, the asymmetry being in opposite directions for the two inverters.

6. Read circuit according to Claim 5, characterised in that one of the supplementary inverters has a p-channel transistor with a high channel width/length ratio and an n-channel transistor with a low channel width/length ratio, and in that the other supplementary inverter has a p-channel transistor with a low channel width/length ratio and an n-channel transistor with a high channel width/length ratio.
